# EUROPEAN PATENT APPLICATION

(11) **EP 4 550 369 A1**
(43) Date of publication of application: **07.05.2025**
(21) Application number: 24204099.6
(22) Date of filing: 02.10.2024
(51) Int. Cl.: H01F 7/18, F16K 37/00

(54) **SOLENOID FAULT DETECTION**

(30) Priority: 02.11.2023 GB 202316810
(71) Applicant: Rolls-Royce plc, London N1 9FX (GB)
(72) Inventor: MERRETT, Benedict, Derby, DE24 8BJ (GB)
(74) Representative: Rolls-Royce plc

(57) **Abstract**

A fault detector (50) for a control system (1) that includes a controller (60), a solenoid driver (70), a current sensor (90) and a solenoid (80). The solenoid driver (70) provides a current to the solenoid (80) in response to a control signal provided by the controller (60) to the solenoid driver (70) and the current sensor (90) measures the current provided by the solenoid driver (70) to the solenoid (80) to determine a current measurement (40). At any moment, the control signal corresponds to one of a demanded zero current, a demanded first current magnitude or a demanded second current magnitude. The fault detector (50) detects a fault based upon a comparison of the current measurement (40) to an expected current range, wherein the expected current range is dependent upon which of the demanded zero current, demanded first current magnitude or the demanded second current magnitude the control system corresponds to at that moment.

## Description

### FIELD

The present disclosure concerns an apparatus for detecting a fault in a solenoid or solenoid driver. Specifically, the present disclosure concerns detection of failure of a solenoid in a safety-critical application.

### BACKGROUND

Solenoid actuation may be used in multiple applications - for example solenoid actuation may be used to bias a fluid flow between a high flow state and a low flow state by controlling a valve. The low flow state of the valve may correspond to zero flow, in which chase the fluid biasing valve is a fluid shut-off valve.

In some environments, correct operation of the solenoid controlled valve may be safety critical, meaning that measuring systems are put in place to verify that the solenoid is operating as intended. For example, a linear actuator or rotary actuator may be fitted to a solenoid-controlled valve, to provide an independent way of verifying operation of the valve. However, these verification systems introduce additional complexity and cost into the apparatus which comprises the solenoid-actuated system.

It is therefore desirable to provide a more straightforward means of verifying correct operation of a solenoid, especially if the solenoid is used in a safety-critical application.

### SUMMARY

According to a first aspect there is provided a fault detector for a control system that includes a controller, a solenoid driver, a current sensor and a solenoid. The solenoid driver provides a current to the solenoid in response to a control signal provided by the controller to the solenoid driver and the current sensor measures the current provided by the solenoid driver to the solenoid to determine a current measurement.

At any moment, the control signal corresponds to one of a demanded zero current, a demanded first current magnitude or a demanded second current magnitude.

The fault detector detects a fault based upon a comparison of the current measurement to an expected current range, wherein the expected current range is dependent upon which of the demanded zero current, demanded first current magnitude or the demanded second current magnitude the control system corresponds to at that moment.

When the control signal corresponds to the demanded first current magnitude, the expected current range may have a lower bound that corresponds to a minimum current that is sufficient to actuate an armature of the solenoid such that the armature translates from a first state to a second state and may have an upper bound that is insufficient to damage the solenoid or solenoid driver.

When the control signal corresponds to the second current magnitude, the expected current range may have a lower bound that corresponds to a minimum current that is sufficient to hold the armature of the solenoid in the second state and may have an upper bound that is insufficient to damage the solenoid or solenoid driver.

When the control signal corresponds to the demanded zero current, the expected current range may have a lower bound of zero and an upper bound that may be is insufficient to actuate the armature of the solenoid such that the armature translates from the first state to the second state.

The lower bound of the expected current range when the control signal corresponds to the demanded first current magnitude may be equal to the upper bound of the expected current range when the control signal corresponds to the demanded second current magnitude.

The lower bound of the expected current range when the control signal corresponds to the demanded second current magnitude may be equal to the upper bound of the expected current range when the control signal corresponds to the demanded zero current.

A fault may be detected if the current measurement is outside the expected current range when the control signal corresponds to at least one of the demanded zero current, the demanded first current magnitude or the demanded second current magnitude.

A minimum current to hold the armature open may be approximately 2.5 amps.

A minimum current to actuate the armature of the solenoid may be approximately 10 amps.

An upper bound current that is insufficient to damage the solenoid or the solenoid driver may be approximately 15 amps.

When the armature of the solenoid is in the first state, a valve connected to the armature may be in a first state; when the armature of the solenoid is in the second state, the valve connected to the armature may be in a second state. The valve may be closed when it is in its first state and may be open when it is in its second state.

The solenoid driver may comprise a switch (for example, a MOSFET), a first voltage monitor that measures a voltage across the switch and an open circuit fault detector (a second voltage monitor) that measures an input voltage to the solenoid.

The control signal may not be provided by the controller to the solenoid driver if an open circuit comprising the solenoid is detected, the open circuit being detected based upon the voltage measured across the switch and the measured input voltage to the solenoid.

The fault detector may categorise a fault type based upon the measured solenoid current, and optionally, the measured input voltage to the solenoid. The fault type may correspond to the identification of a failed component of the control system, such as the solenoid or solenoid driver.

The fault type may be recorded within a computer memory, the computer memory being accessible by a user.

A power supply to the solenoid driver may be electrically isolated from the solenoid driver in response to detection of the fault by the fault detector. The fault detector may provide an output (a signal) to cause the electrical isolation of the solenoid driver. Electrically isolating the power supply to the solenoid driver may be performed by a component of the control system that is independent of the controller.

The solenoid may be a safety critical solenoid. The safety critical solenoid may, for example, be a solenoid of a fluid biasing valve such as a fuel shut-off valve of a gas turbine engine fuel system. Alternatively, the safety critical solenoid may be a solenoid of a fluid biasing valve of another safety critical application. An example of another safety critical application is a fluid circuit of a nuclear reactor.

The fault detector may detect movement of the armature of the solenoid based at least in part on a variation in the current measurement provided to the fault detector.

According to a second aspect there is provided a gas turbine engine comprising a fault detector as disclosed in any of the above paragraphs.

An example of a "control system" is a "FADEC".

The term, "FADEC" or "Full Authority Digital Engine Control" as used herein means a computer-managed aircraft ignition and engine control system that is used in modern commercial and military aircraft to control all aspects of engine performance digitally, in place of technical or analogue electronic controls.

The skilled person will appreciate that except where mutually exclusive, a feature described in relation to any one of the above aspects may be applied mutatis mutandis to any other aspect. Furthermore except where mutually exclusive any feature described herein may be applied to any aspect and/or combined with any other feature described herein.

### BRIEF DESCRIPTION OF THE DRAWINGS

Embodiments will now be described by way of example only, with reference to the Figures and Tables, in which:
**FIG.** 1 is a sectional side view of a gas turbine engine;
**FIG.** 2 is a schematic illustration of a staged combustion system;
**FIG.** 3 illustrates an example current waveform to actuate a solenoid;
**FIG.** 4 illustrates a first example of a measurement arrangement to determine the health of a solenoid;
**FIG.** 5 illustrates an example relationship between current magnitude and solenoid detection thresholds;
**FIG.** 6 illustrates a second example of a measurement arrangement to determine the health of a solenoid;
**FIG.** 7 illustrates a third example of a measurement arrangement to determine the health of a solenoid;

**Table 1** illustrates how the state of a solenoid and/or solenoid driver may be determined based upon current measurements versus current thresholds; and

**Table 2** illustrates how the state of a solenoid and/or solenoid driver may be determined based upon current and voltage measurements versus respective current and voltage thresholds.

### DETAILED DESCRIPTION

Aspects and embodiments of the present disclosure will now be discussed with reference to the accompanying figures. Further aspects and embodiments will be apparent to those skilled in the art.

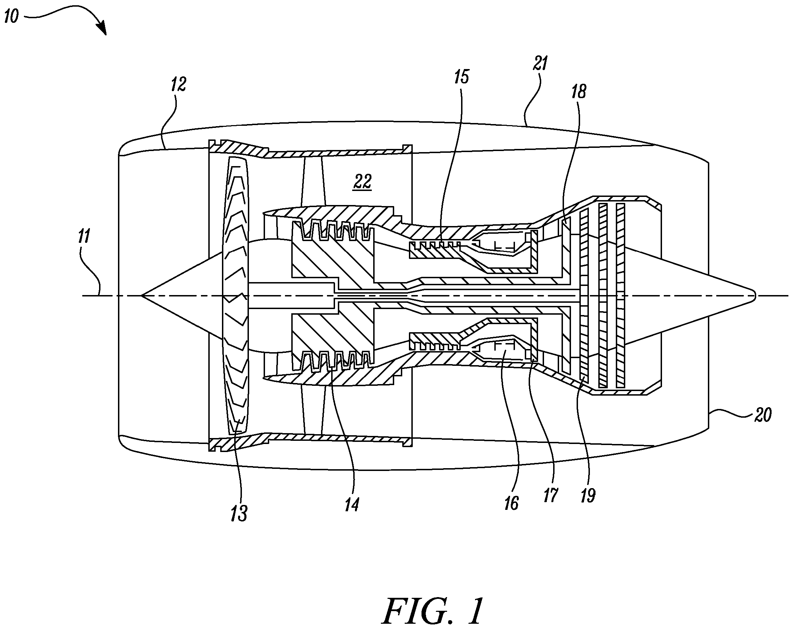

With reference to FIG. 1, a gas turbine engine is generally indicated at 10, having a principal and rotational axis 11. The engine 10 comprises, in axial flow series, an air intake 12, a propulsive fan 13, an intermediate pressure compressor 14, a high-pressure compressor 15, combustion equipment 16, a high-pressure turbine 17, an intermediate pressure turbine 18, a low-pressure turbine 19 and an exhaust nozzle 20. A nacelle 21 generally surrounds the engine 10 and defines both the intake 12 and the exhaust nozzle 20.

The gas turbine engine 10 works in the conventional manner so that air entering the intake 12 is accelerated by the fan 13 to produce two air flows: a first air flow into the intermediate pressure compressor 14 and a second air flow which passes through a bypass duct 22 to provide propulsive thrust. The intermediate pressure compressor 14 compresses the air flow directed into it before delivering that air to the high pressure compressor 15 where further compression takes place.

The compressed air exhausted from the high-pressure compressor 15 is directed into the combustion equipment 16 where it is mixed with fuel and the mixture combusted. The resultant hot combustion products then expand through, and thereby drive the high, intermediate and low-pressure turbines 17, 18, 19 before being exhausted through the nozzle 20 to provide additional propulsive thrust. The high 17, intermediate 18 and low 19 pressure turbines drive respectively the high pressure compressor 15, intermediate pressure compressor 14 and fan 13, each by suitable interconnecting shaft.

Other gas turbine engines to which the present disclosure may be applied may have alternative configurations. By way of example such engines may have an alternative number of interconnecting shafts (e.g. two) and/or an alternative number of compressors and/or turbines. Further the engine may comprise a gearbox provided in the drive train from a turbine to a compressor and/or fan.

It is desirable to reduce the emissions produced by a gas turbine engine. For example, it is desirable to reduce the oxides of nitrogen (NO, NO₂, commonly collectively referred to as "NOₓ") emitted by the gas turbine engine 10 following combustion of fuel in air, within combustion equipment 16. It is also desirable to reduce peak stresses (for example, peak transient stresses) experienced by components of the turbines 17, 18, 19 during operation, as this may extend the operational life of these components.

To this end combustion equipment 16 may be a staged combustion system - i.e., combustion equipment 16 may comprise a first group 16' of fuel injectors that are configured to be operable over the full power range of the gas turbine engine, and a second group 16" of fuel injectors that are configured to operate only above a threshold power level of the gas turbine engine.

Fuel supplied to the second group 16" of fuel injectors may be switched on and off, based upon the desired engine power (for example, in the case of an aero gas turbine engine, a desired engine thrust setting).

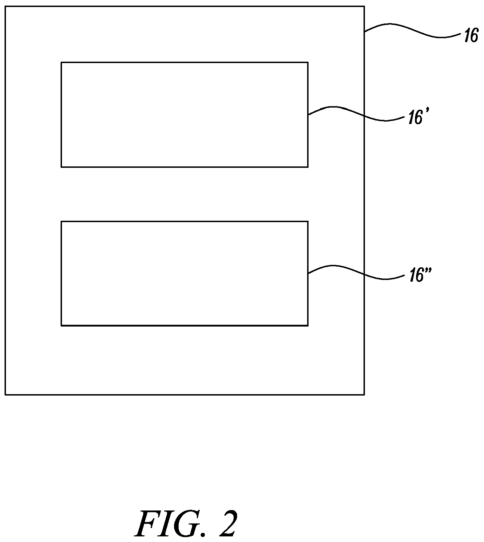

Fuel may be switched off to the second group 16" of fuel injectors by placing at least one shut-off valve (not shown in FIG. 2) between a fuel supply to the engine and the second group of fuel injectors 16". Thus, by actuating the at least one shut-off valve, fuel may be either supplied or not supplied to the second group 16" of fuel injectors.

Some gas turbine engine types may comprise a single at least one shut-off valve.

Other gas turbine engine configurations may comprise a plurality of shut-off valves.

### For example: -

Each injector of the second group 16" of fuel injectors may be provided with its own shut-off valve. This arrangement may be advantageous due to the high level of functional flexibility it introduces, permitting multiple fuel staging configurations, dependent on flight condition or engine power setting. This arrangement may also permit the gas turbine engine to continue to be operated with a single failed solenoid, affecting a single fuel injector, as opposed to other arrangements in which a single failed solenoid affects multiple fuel injectors, with a greater detrimental effect on peak available engine thrust and/or circumferential turbine entry temperature distribution.

Alternatively, the second group 16" of fuel injectors may be split into a plurality of sub-groups, with each sub-group of the second group 16" of fuel injectors having its own shut-off valve. This arrangement may be advantageous because it reduces the total number of shut-off valves, saving weight and reducing complexity of both the gas turbine engine and its control system.

Alternatively, a single shut-off valve may be provided, such that actuation of the shut-off valve simultaneously switches on or off the fuel supplied to all the second group 16" of fuel injectors. This arrangement may be advantageous because it enable further weight and complexity reductions, albeit at the potential expense of flexibility of control.

The at least one shut-off valve may be controlled by a control system such as a FADEC (Full Authority Digital Engine Control).

By suitable selection of when to open and when to close the at least one shut-off valve, the NOₓ emissions of gas turbine engine 10 may be reduced.

Alternatively or additionally, by suitable selection of when to open and when to close the at least one shut-off valve, a margin of safety of operation of the gas turbine engine 10 may be improved.

For example, the likelihood of a combustor flame-out occurring during transient engine operation or engine surge recovery may be reduced by reducing or even shutting off the fuel supplied to a portion of the fuel injectors such that the fuel flow supplied to other fuel injectors is increased. This increases the local combustion temperatures attributed to the higher flowing fuel injectors, reducing the risk of a combustor flame-out.

The portion of fuel injectors may form part of either the first group 16' of fuel injectors or the second group 16"of fuel injectors.

In these embodiments at least one fuel biasing valve may be utilised, in place of at least one fuel shut off valve.

A fuel biasing valve is similar to a fuel shut-off valve in that it is bistable, i.e., it has a high flow state and a low flow state, with toggling between the high flow state and the low flow state occurring due to action of a solenoid.

A fuel biasing valve differs from a fuel shut-off valve in that the low flow state of the fuel biasing valve is non-zero, i.e., a minimum fuel flow level is maintained at all times, irrespective of whether the valve is in its high flow state of low flow state.

Changing the configuration of which fuel injectors are supplied with fuel, and which are not, changes the spatial distribution of the temperature of exhaust gases at exit from the combustor, prior to entry into the high-pressure turbine 17.

However, if the spatial temperature distribution of the exhaust gases is substantially different to expectation at a power setting, this may have a detrimental effect on the operation of the gas turbine engine 10. In a worst case, this can lead to a failure of a turbine 17, 18, 19 of the gas turbine engine 10, raising a concern for the gas turbine engine and the aircraft to which the gas turbine engine 10 is fitted.

Such a difference between actual and expected spatial distribution of combustor exhaust gases may occur if fuel is incorrectly supplied to at least one fuel injector. This may occur if the shut-off valve that is fluidically connectable to the at least one fuel injector is in an incorrect position. If the shut-off valve is actuated by a solenoid, this may occur if there is a problem with the actuation of solenoid or its solenoid driver, which provides a current to the solenoid for actuation purposes.

For a solenoid actuated shut-off valve, it is therefore desirable to be able to detect whether the solenoid and/or the solenoid driver are functioning correctly.

As is now disclosed, the correct functioning of the solenoid driver may be determined by suitable measurement of current, and optionally, voltage measurements, relating to the solenoid driver.

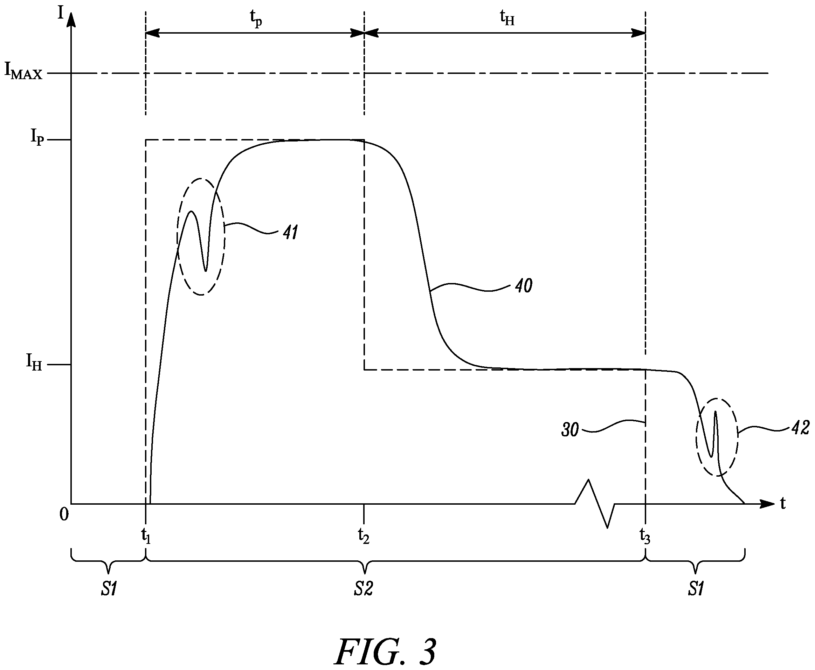

FIG. 3 illustrates an example demanded current 30 for operation of a solenoid, and an example actual current 40 provided to the solenoid, that may be measured, as a function of time, t.

The example of FIG. 3 represents operation under non-fault conditions.

In FIG. 3, the solenoid is initially in a first demanded state, S1, corresponding to zero demanded current. The first demanded state S1 of the solenoid may correspond to a first demanded state of a shut-off valve that is mechanically connected to a component of the solenoid, such as a solenoid armature. When the solenoid is in its first demanded state S1, the shut-off valve mechanically connected to it may be closed.

At a time t₁, a demand is provided to change the state of the solenoid from its first state S1, to a second state, S2. This causes the shut-off valve that is mechanically connected to the solenoid to move from its first state to its second state, i.e., the shut-off valve is demanded to open.

The idealised current demand to cause the solenoid to open comprises a first current demand level I_{P}, corresponding to a demanded "pull-in" current level, and a subsequent, second current level I_{H}, corresponding to a demanded "hold" current level.

The demanded pull-in current I_{P} is provided for a time duration, t_{P}, that is equal to t₂-t₁. The time duration t_{P} is set for a sufficient time to move the solenoid armature, and the shut-off valve mechanically connected to the solenoid armature from the first state to the second state.

The time period t_{P} (the "pull-in time") may be up to 100ms.

After expiry of the pull-in time, at time t2, the demanded current falls from the pull-in current level I_{P} to the demanded hold current level I_{H}.

The demanded hold current level I_{H} is set such that it is sufficient to keep the solenoid in the second state S2 (for example, to hold the shut-off valve mechanically connected to the solenoid open) but is insufficient to cause the solenoid to change from the first demanded state S1 to the second demanded state S2.

Reducing the demanded current form I_{P} to I_{H} is advantageous because it reduces energy consumption and solenoid heating, without compromising the operation of the solenoid.

This may be beneficial because the hold current may be supplied for a significantly longer duration (the "hold time") than the pull-in current (the "pull-in time"), i.e., t_{H} >> tₚ.

Once the solenoid has transitioned to the second state S2, it is held in the second state by application of hold current I_{H} until there is a demand to change state from the second state S2 back to the first state S1.

The hold time t_{H} for which the solenoid is demanded to be in the second state (t₃ - t₁) is dependent upon how the solenoid is utilised - for example how the system within which the solenoid is comprised, is operated.

For example, if the solenoid is comprised within a fuel system for an aero gas turbine engine, the hold time t_{H} may be measured in hours, corresponding to the majority of the duration of a flight of an aircraft equipped with the gas turbine engine. The time t₃, may for example, correspond with a "top of descent" condition for operation of an aircraft comprising the gas turbine engine 10, at which the gas turbine engine 10 is throttled back from a cruise power setting, at or towards an engine idle power setting, such that the aircraft may lose altitude, in preparation for landing.

FIG. 3 also illustrates that under normal operation, the actual (measured) solenoid current 40 follows the demanded current 30, but may lag it, during transition between demanded current levels. For example, a lag is present when the solenoid is demanded to change from first state S1 to second state S2, and when demanded to change state from the second state S2 to the first state S1. A lag is also present when the demanded current reduces from I_{P} to I_{H}.

The actual current 40 may be generated using pulse wave modulation (PWM), as is known in the art.

FIG. 3 also illustrates that during transitions between states S1 and S2, the actual current 40 may comprise an inflexion (a temporal fluctuation in magnitude of the actual current). For example, first inflexion 41 occurs because of a demand to change state from the first state S1 to the second state S2, while second inflexion 42 occurs because of a demand to change state from the second state S2 to the first state S1.

Inflexions 41, 42 are caused by the generation of an induced back EMF in a coil of the solenoid, due to movement of the solenoid armature. Hence, an inflexion does not occur when the demanded current is reduced from I_{P} to I_{H} because there is no corresponding movement of the solenoid armature when this occurs.

As is now disclosed, by measuring the actual current 40 and comparing it to the demanded current 30, it is possible to determine whether the solenoid receiving the actual current 40 is performing as expected.

From FIG. 3 it will be understood that the current required to operate the solenoid varies between several levels.

These are a nominal zero current level (corresponding to a demanded first state S1 of the solenoid), a nominal pull-in current level (corresponding to a current to cause the solenoid to transition from its first state S1 to its second state S2), and a nominal hold current level (corresponding to holding the solenoid in its second state S3).

It will also be appreciated that when operating normally, the maximum demanded current 30 and maximum actual current 40 should be below a maximum safe current limit for the solenoid driver I_{MAX}.

As FIG. 3 represents expected current levels, it shows that the maximum of the actual current 40 is substantially equal to the demanded pull-in current, of magnitude I_{P}, but is lower than the maximum safe current level I_{MAX}, and higher than the hold current I_{H}.

By measuring the actual current 40, and comparing the actual current 40 to zero, I_{H}, I_{P} and/or I_{MAX}, it is possible to determine whether the solenoid and/or solenoid driver is operating as intended. Current measurement, and comparison with expectation, may therefore be used to assess the health of the solenoid and/or the solenoid driver circuit.

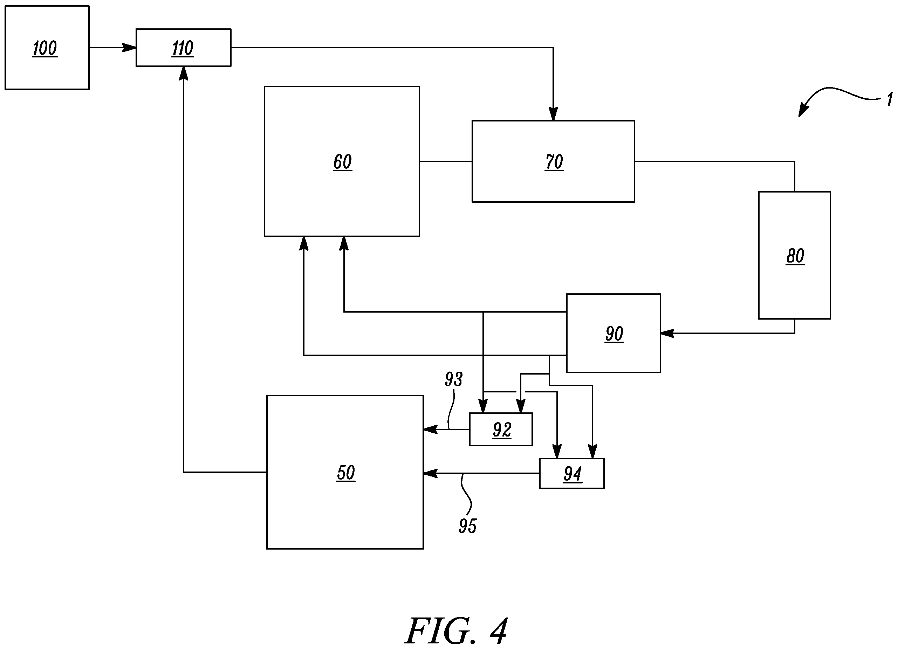

FIG. 4 illustrates a first example of how this assessment may be made by a fault detector 50 for a FADEC 1.

In the example of FIG. 4, the FADEC 1 comprises a fault detector 50, a controller 60, a solenoid driver 70 that is controlled by controller 60; a solenoid 80 that is provided with actual current 40 by the solenoid driver 80, and a current sensor 90 that measures the actual current 40 flowing through solenoid 80.

Although not shown in FIG. 4, in some embodiments, the controller 60, solenoid driver 70, solenoid 80 and current sensor 90 of FADEC 1 may be configured such that they form parallel systems that are each capable of energising the solenoid 80.

Such parallel systems may be referred to as "lanes". Each lane incorporates duplicate hardware and/or software. In a two-lane system, the first lane may be referred to as "Lane A", while the second lane may be referred to as "Lane B". In such a system, at any one time, only one of Lane A and Lane B controls energisation of the solenoid 80.

In such a system, solenoid 80 may comprise a first coil forming part of Lane A, and a second coil forming part of Lane B. At any one time, the solenoid coil which does not form part of the Lane that is control, may be used to monitor the current provided to the solenoid by the controlling Lane.

That is, if Lane A is in control, demanded current 30 is provided to the Lane A solenoid coil, with actual current 40 monitored by the Lane B solenoid coil and vice versa.

It will be appreciated that other configurations for providing a current to a solenoid, and measuring the actual current provided are also possible.

Although not shown in FIG. 4, solenoid driver 70 comprises a switch, such as a MOSFET the switching of which by, for example, pulse wave modulation (PWM), creates the actual current 40.

Current sensor 90 measures the actual current 40 flowing through solenoid 80. Current measurement may be by resistive means (for example, by measuring a voltage across a known resistor), inductive means or by using a hall effect probe. The current measurement is provided to a first current comparator 92 and a second current comparator 94.

The first current comparator 92 and second current comparator 94 each compare the actual current to at least one current threshold. For example, the first current comparator 92 and second current comparator 94 may compare actual current 40 to at least one of zero current, I_{P}, I_{H} and/or I_{MAX}.

The output 93 of the first current comparator 92 and the output 95 second current comparator 94 are logical outputs, having logical states of either "1" or "0".

In the example illustrated in FIG. 4, the first current comparator 92 and the second current comparator 94 are not comprised within the fault detector 50. It will be readily appreciated that in other embodiments, the first current comparator 92 and the second current comparator 94 are comprised within the fault detector 50.

Instead, the output 93 of the first current comparator 92 and the output 95 second current comparator 94 are continually provided to the fault detector 50 as inputs. Outputs 93 and 95 are therefore simultaneously available to the fault detector 50 and may be used by the fault detector 50 either singly or in combination.

In preferred examples, it is envisaged that outputs 93 and 95 are used by the fault detector 50 in combination.

Output 93 may also be referred to as LOGIC_{IP}, as it represents the logical state of the pull-in monitor. At any moment, the value of LOGIC_{IP} indicates when the actual current 40 is greater than the pull-in current required to cause the solenoid to transition from the first state S1 to the second state S2 but is also less than the maximum safe current for the solenoid and/or solenoid driver

Output 95 may also be referred to as LOGIC_{IH}, as it represents the logical state of the hold monitor. At any moment, the value of LOGIC_{IH} indicates when the actual current 40 is greater than the hold current required to cause the solenoid to remain in the second state S1 but is also less than the maximum safe current for the solenoid and/or solenoid driver.

By interrogating the values (0 or 1) of LOGIC_{IP} and LOGIG_{IH}, the fault detector 50 determines whether solenoid driver 70 and/or solenoid 80 are functioning correctly.

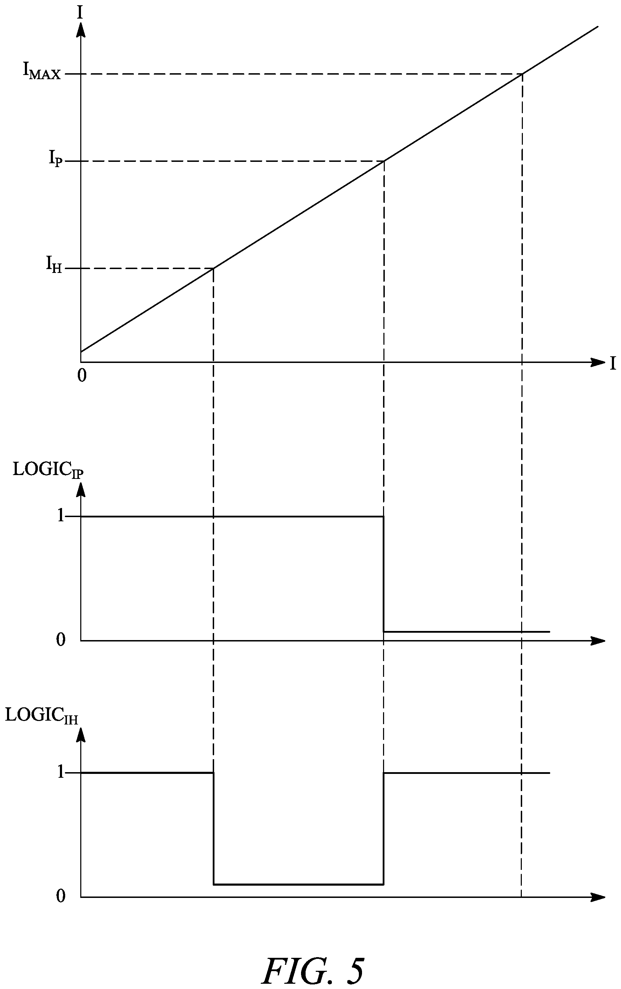

This may be better understood by reference to FIG. 5 and Table 1.

In the example of FIG. 5, LOGIC_{IP} is set to "1" for actual current values between 0 and I_{P}, and to "0" for values greater than I_{P}.

In the example of FIG. 5, LOGIC_{IH} is set to "1" for actual current values between 0 and I_{H}, and for actual current values greater than I_{MAX}. LOGIC_{IH} is set to "0" for current values between I_{H} and I_{MAX}.

The demanded current values I_{P}, I_{H} and I_{MAX} are thresholds.

In some embodiments, a tolerance may be applied to at least one of these thresholds. For example, a tolerance may be applied to account for manufacturing variation between solenoids made to a common design to ensure that any solenoid made to that design receives sufficient current to actuate the armature of that solenoid, and consequently, to actuate a shut-off valve that is mechanically connected to that armature.

Optionally, a confirmation time may be applied to confirm the logical state of LOGIC_{IP} and/or LOGIC_{IH}.

Application of a confirmation time may be desirable if the status of LOGIC_{IP} and/or LOGIC_{IH} is to be determined at a time at or close to a demanded switch from first state S1 to second state S2, or vice versa, due to the lag that may occur between demanded current 30 and actual current 40 (see FIG. 3).

The magnitude of the confirmation time may be based at least in part on the degree of lag between the demanded current 30 and actual current 40.

In some embodiments, the fault detector 50 is in operation whenever power is provided to the FADEC.

In other embodiments, the fault detector 50 is activated at discrete moments - for example, to provide confirmation that the solenoid has changed state, or as part of a scheduled check, for example, on gas turbine engine start or shut-down

The fault detector has as input, the demanded state of the solenoid, and the associated demanded current. In other words, at any moment, fault detector 50 has as input, information concerning whether the solenoid is demanded to be in the first state S1 or second state S2. If the solenoid is demanded to be in second state S2, the fault detector 50 has knowledge of whether at that moment, the solenoid is demanded to be in its initial pull-in current magnitude period (i.e., within pull-in time period t_{P}), or subsequent hold current magnitude period (i.e., within hold time period t_{H}).

Table 1 illustrates how this information, plus the combination of logic states of LOGIC_{IP} and LOGIC_{IH} may be used to determine the health of the solenoid and/or solenoid driver, as for any given combination of values of LOGIC _{IP} and LOGIC_{IH}, determination of whether the solenoid and/or solenoid driver is functioning correctly is additionally dependent on the demanded solenoid state at that instant.

For example, the combination of LOGIC_{IP} = 1 and LOGIC_{IH} = 1 corresponds to an actual current 40 that is greater than zero, but less than I_{H} (minimum hold current). It will be appreciated that this current range is within the expected range if the solenoid is demanded to be it its first state S1 (depowered), but not if, the solenoid is demanded to be in its second state S2 (powered).

The fault detector 50 is therefore capable of distinguishing between normal operation and abnormal operation, in real-time.

This distinguishing may take place via a look-up table or logical decision tree, as is known in the art.

**Table 1: Determined state of solenoid and/or solenoid driver versus current threshold.**

| LOGIC_{IP} | LOGIC_{IH} | Demanded Solenoid State S1 (depowered) | Demanded Solenoid State S2 (hold period) | Demanded Solenoid State S2 (pull-in period) |
|---|---|---|---|---|
| 1 | 1 | OK | Fault: Solenoid likely destaged | Fault: Solenoid likely not pulled in |
| 1 | 0 | Drive Fault | OK | Fault: Solenoid likely not pulled in |
| 0 | 1 | Drive Fault | Drive Fault (high current) | Drive Fault (high current) |
| 0 | 0 | Drive Fault | Drive Fault (high current) | OK |

If a fault is detected, the fault detector 50 may cause a status flag to be set in a computer memory, to record the type of fault detected.

The computer memory may be comprised within the FADEC or a maintenance computer that is in communication with the FADEC.

The computer memory may be accessible by a user such as a maintenance engineer. Thus, the maintenance engineer may quickly determine which component has failed and take appropriate action. This is desirable, as more rapid replacement of a failed component reduces the operational impact (and hence, expenses incurred by an operator) whilst maintenance work is undertaken.

If a fault is detected, it may be desirable to isolate the power supply to the solenoid driver 70, such that solenoid 80 is depowered and a shut-off valve that is mechanically connected to the solenoid, closes.

Referring again to FIG. 4, fault detector 50 may be coupled to an electrical isolator 110. The electrical isolator 110 is placed between the power supply 100 to the solenoid driver 70, and the solenoid driver 70. The electrical isolator 110 isolates the solenoid driver 70 from the power supply 100 in response to detection of a fault by the fault detector 50. Detection of a fault causes the fault detector to send an output (a signal) to cause the electrical isolation of the solenoid driver. In this way, the electrical power supply and the solenoid driver may be electrically decoupled.

If a fault is detected, and such a power isolation would have a detrimental effect on the operational capability of the gas turbine engine 10 (for example, by limiting the maximum thrust the engine may develop, or resulting in a non-desirable spatial temperature distribution at turbine entry), the fault detector may additionally forward a warning message to the flight deck of the aircraft, or command the gas turbine engine 10 to be shut-down automatically.

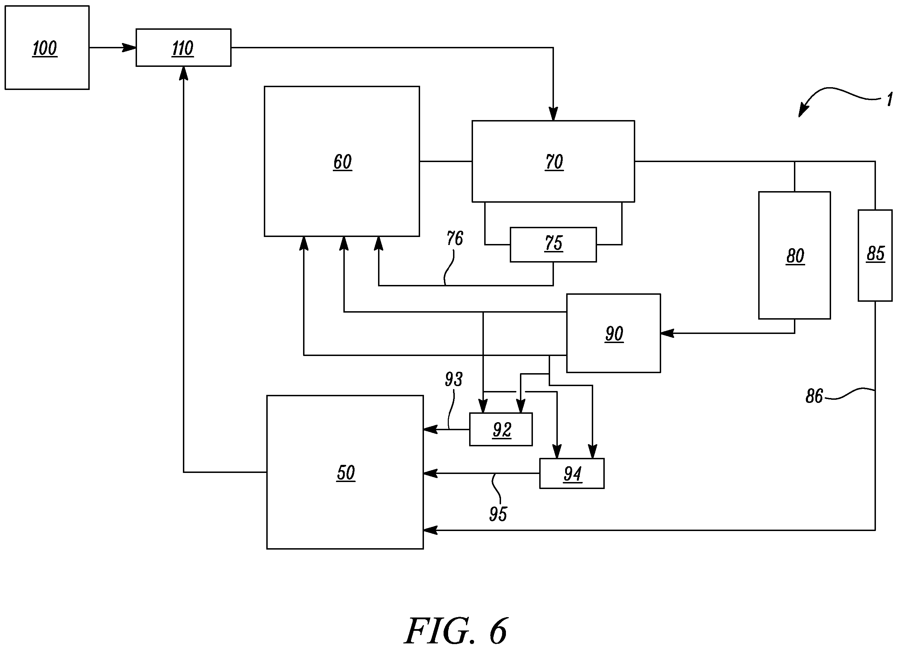

Further optional diagnostic improvements are also envisaged, as illustrated in FIG. 6.

For example, a first voltage monitor 75 may be provided across the switch of the solenoid driver 70. The output 76 of the first voltage sensor 75 is provided to the controller 60 and may be monitored to determine if the switch of the solenoid driver 70 is functioning correctly.

Alternatively or additionally, a second voltage monitor 85 may also be provided.

The second voltage monitor 85 measures the potential difference across solenoid 80 - i.e., the input voltage to solenoid 80. In some examples, the output 86 of the second voltage monitor 85 may be used if either the output of the pull-in monitor or the output of the hold monitor is determined to be out of its expected range.

The output 86 of the second voltage monitor 85 represents an input voltage to solenoid 80 and may be analysed to determine its frequency. The frequency may be compared to an expected switching frequency of the switch of solenoid driver 70.

Table 2 provides an example of faults which may be detected, based upon current and voltage measurements when compared against expectation. The combination of current and voltage measurements may be used to provide more information concerning which component has failed, enabling more rapid trouble-shooting and repair by a maintenance team.

**Table 2: Fault Diagnosis for a solenoid and/or solenoid driver based upon current and voltage measurements versus respective current and voltage thresholds.**

| Fault | Current Measurement | Voltage Monitor |
|---|---|---|
| Solenoid open circuit fault | Reads near 0 value | Normal readings |
| Solenoid short Over Coil | Instantaneous current changes from out-of-range high to 0 in phase with voltage monitor | Normal readings |
| Solenoid high side sort | Reads near 0 value | Normal readings |
| Solenoid low side short | Reads near 0 value | Normal readings |
| Drive stuck off | Reads near 0 value | Reading stuck high |
| Drive stuck on | Reads high value continually | Reading stuck low |
| No fault detected | Normal readings | Normal readings |

The fault detector 50 is therefore capable of distinguishing between normal operation and abnormal operation, in real-time.

This distinguishing may take place via a look-up table or logical decision tree, as is known in the art.

As in previous examples, if a fault is detected, the fault detector 50 may cause a status flag to be set in a computer memory, to record the type of fault detected for analysis by a maintenance engineer, and/or cause a message to be forwarded a warning message to the flight deck of the aircraft that comprises the gas turbine engine and/or command the gas turbine engine 10 to be shut-down automatically, as appropriate.

In the preceding examples, the first current comparator 92 and the second current comparator 94 are external to the fault detector 50 and provide their respective outputs 93, 95 as logical inputs to the fault detector 50.

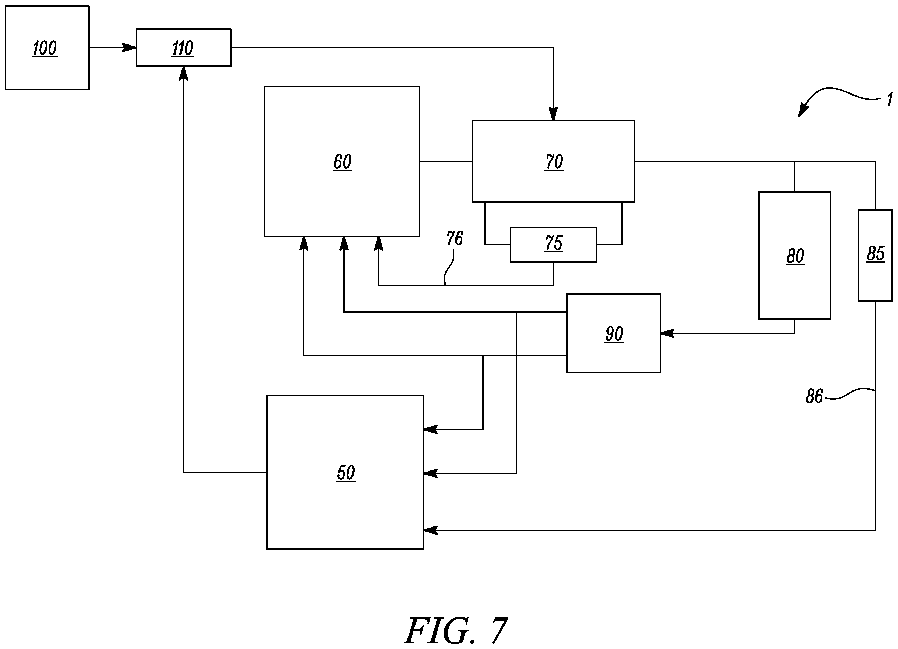

FIG. 7 provides a further example in which the fault detector is directly provided with the output from current sensor 90. Although not shown in FIG. 7, the fault detector 50 of FIG. 7 comprises the first current comparator 92 and the second current comparator 94. The respective outputs 93, 95 of the first current comparator 92 and second 94 current comparator are processed by the fault detector as previously disclosed.

However, the example of FIG. 7 has the advantage that as the fault detector can independently measure and analyse actual current 40 provided to the solenoid.

FIG. 3 provides an illustration of how, when the solenoid 80 is energised and de-energised, resulting movement of an armature of the solenoid causes a respective first inflexion 41 and second inflexion 42 in the detected measured current 40.

As the solenoid armature is mechanically connected to a shut-off valve, it follows that the presence of inflexions 41, 42 in actual detected current 40 is an indicator that the shut-off valve to which the solenoid armature is mechanically connected, has actuated expected.

This is advantageous in the scenario that a shut-off valve sticks in a fixed position, such that the solenoid armature is restrained from moving when the solenoid is energised (state S1 changing to state S2) or de-energised (state S2 changing to state S1).

United States patent application US 2021/0222634 A1 discloses how the actual current 40 may be processed to detect movement of the solenoid armature, as a proxy for movement of a connected valve. Thus, by combination of the above disclosure in relation to Figs 2 - 6 with the teaching of US 2021/0222634 A1, a further improvement may be made in which it is possible to additionally detect whether the shut-off valve that is mechanically connected to the solenoid armature has stuck, despite normal operation of the solenoid and solenoid driver. In this scenario, a maintenance message, warning message and/or shutdown request may be triggered, as previously disclosed.

It will be appreciated that US2021/0222634A1 merely provides one example by which a stuck solenoid armature may be detected, for use in combination with the solenoid and/or solenoid driver failure detection now disclosed.

It will be understood that the invention is not limited to the embodiments above-described and various modifications and improvements can be made without departing from the concepts described herein.

For example, although the fault detector is disclosed above in relation to the detection of a solenoid or solenoid drive fault, in which the solenoid is comprised within a gas turbine engine, it will be readily appreciated that the invention is applicable to any application in which determination that a solenoid or solenoid driver is functioning normally is safety critical.

For example, the fault detector now disclosed may be comprised with a control system for a nuclear power station.

Additionally, although the above disclosure relates to solenoid actuation of a valve that is configured to open when the solenoid is powered, and closed when the solenoid is depowered, it will be recognised that this is application specific, i.e., the above disclosure is equally applicable to solenoid actuation of a valve that is configured to close when the solenoid is powered, and to open when the solenoid is depowered.

Except where mutually exclusive, any of the features may be employed separately or in combination with any other features and the disclosure extends to and includes all combinations and sub-combinations of one or more features described herein.

## Claims

1. A fault detector (50) for a control system (1) that includes a controller (60), a solenoid driver (70), a current sensor (90) and a solenoid (80), wherein:
in response to a control signal provided by the controller (60) to the solenoid driver (70), the solenoid driver (70) provides a current to the solenoid (80);
the current sensor (90) measures the current provided by the solenoid driver (70) to the solenoid (80) to determine a current measurement (40);
wherein at any moment, the control signal corresponds to one of a demanded zero current, a demanded first current magnitude or a demanded second current magnitude; and
the fault detector (50) detects a fault based upon a comparison of the current measurement (40) to an expected current range, wherein the expected current range is dependent upon which of the demanded zero current, demanded first current magnitude or the demanded second current magnitude the control system corresponds to at that moment.

2. The fault detector (50) of claim 1, wherein:
when the control signal corresponds to the demanded first current magnitude, the expected current range has a lower bound that corresponds to a minimum current that is sufficient to actuate an armature of the solenoid such that the armature translates from a first state to a second state, and an upper bound that is insufficient to damage the solenoid or solenoid driver;
when the control signal corresponds to the second current magnitude, the expected current range has a lower bound that corresponds to a minimum current that is sufficient to hold the armature of the solenoid in the second state, and an upper bound that is insufficient to damage the solenoid or solenoid driver; and
when the control signal corresponds to the demanded zero current, the expected current range has a lower bound of zero and an upper bound that is insufficient to actuate the armature of the solenoid such that the armature translates from the first state to the second state.

3. The fault detector (50) of claim 2, wherein:
the lower bound of the expected current range when the control signal corresponds to the demanded first current magnitude is equal to the upper bound of the expected current range when the control signal corresponds to the demanded second current magnitude; and/or,
the lower bound of the expected current range when the control signal corresponds to the demanded second current magnitude is equal to the upper bound of the expected current range when the control signal corresponds to the demanded zero current.

4. The fault detector (50) of claim 2 or 3, wherein a fault is detected if the current measurement is outside the expected current range when the control signal corresponds to at least one of the demanded zero current, the demanded first current magnitude or the demanded second current magnitude.

5. The fault detector (50) of any one of claims 2 to 4, wherein:
when the armature of the solenoid (80) is in the first state (S1) a valve connected to the armature is in a first state; and,
when the armature of the solenoid (80) is in the second state (S2), the valve connected to the armature is in a second state.

6. The fault detector (50) of claim 5, wherein the valve is closed when in its first state, and the valve is open when in its second state.

7. The fault detector (50) of any preceding claim, wherein the solenoid driver (70) comprises:
a switch;
a first voltage sensor (75) measuring a voltage across the switch; and/or
a second voltage sensor (85) measuring an input voltage to the solenoid.

8. The fault detector (50) of claim 7, wherein the control signal is not provided by the controller (60) to the solenoid driver (70) if an open circuit comprising the solenoid (80) is detected, the open circuit being detected based upon the input voltage to the solenoid measured by the second voltage sensor (85).

9. The fault detector (50) of any preceding claim, wherein the fault detector (50) categorises a fault type corresponding to an identification of a failed control system component, based upon the measured current and the measured input voltage to the solenoid (80).

10. The fault detector (50) of claim 9, wherein the fault type is recorded within a computer memory, the computer memory being accessible by a user.

11. The fault detector (50) of any preceding claim, wherein in response to detection of the fault by the fault detector, the fault detector provides an output to cause a power supply to the solenoid driver to be electrically isolated from the solenoid driver.

12. The fault detector (50) of claim 11, wherein electrically isolating the power supply to the solenoid driver is performed by a component of the control system that is independent of the controller (60).

13. The fault detector (50) of any preceding claim, wherein the solenoid (80) is a safety critical solenoid (80) of a fluid biasing valve.

14. The fault detector (50) of any preceding claim, wherein the fluid biasing valve is a fuel shut-off valve of a gas turbine engine fuel system.

15. A gas turbine engine (10) including the fault detector (50) of any preceding claim.
